Europäisches Patentamt

European Patent Office

Office européen des brevets

(19)

(11) **EP 0 681 760 B1**

(12) **EUROPÄISCHE PATENTSCHRIFT**

(45) Veröffentlichungstag und Bekanntmachung des Hinweises auf die Patenterteilung:
**26.03.1997 Patentblatt 1997/13**

(21) Anmeldenummer: **94904989.4**

(22) Anmeldetag: **26.01.1994**

(51) Int Cl.6: **H03K 3/84**, G06F 7/58

(86) Internationale Anmeldenummer:
**PCT/DE94/00091**

(87) Internationale Veröffentlichungsnummer:
**WO 94/17591 (04.08.1994 Gazette 1994/18)**

(54) **RÜCKGEKOPPELTES SCHIEBEREGISTER ZUM ERZEUGEN VON PSEUDOZUFALLSZAHLENFOLGEN DARSTELLENDEN DIGITALEN SIGNALEN**

FEEDBACK SHIFT REGISTER FOR GENERATING DIGITAL SIGNALS REPRESENTING SERIES OF PSEUDO-RANDOM NUMBERS

REGISTRE A DECALAGE A BOUCLE FERMEE PERMETTANT DE GENERER DES SIGNAUX NUMERIQUES REPRESENTANT DES SUITES DE NOMBRES PSEUDO-ALEATOIRES

(84) Benannte Vertragsstaaten:
**CH DE ES FR GB IT LI**

(30) Priorität: **27.01.1993 DE 4302830**

(43) Veröffentlichungstag der Anmeldung:
**15.11.1995 Patentblatt 1995/46**

(73) Patentinhaber: **SIEMENS AKTIENGESELLSCHAFT
80333 München (DE)**

(72) Erfinder:
• **WOLF, Andreas
  D-12157 Berlin (DE)**

• **AHRWEILER, Hans, Werner
  D-12161 Berlin (DE)**

(56) Entgegenhaltungen:
**DE-A- 2 734 302**

• **IEE PROCEEDINGS E (COMPUTERS AND DIGITAL TECHNIQUES), JAN. 1988, UK, 135, 1, 67 - 69 Bd. 8049E , ISSN 0143-7062 Chambers W G et al 'Generators for sequences with near-maximal linear equivalence'**

## Beschreibung

Die Erfindung bezieht sich auf ein rückgekoppeltes Schieberegister zum Erzeugen von Pseudozufallszahlenfolgen darstellenden digitalen Signalen mit n Stufen und Exclusiv-ODER-Schaltungen in der Rückkopplungslogik sowie mit einem Taktgenerator.

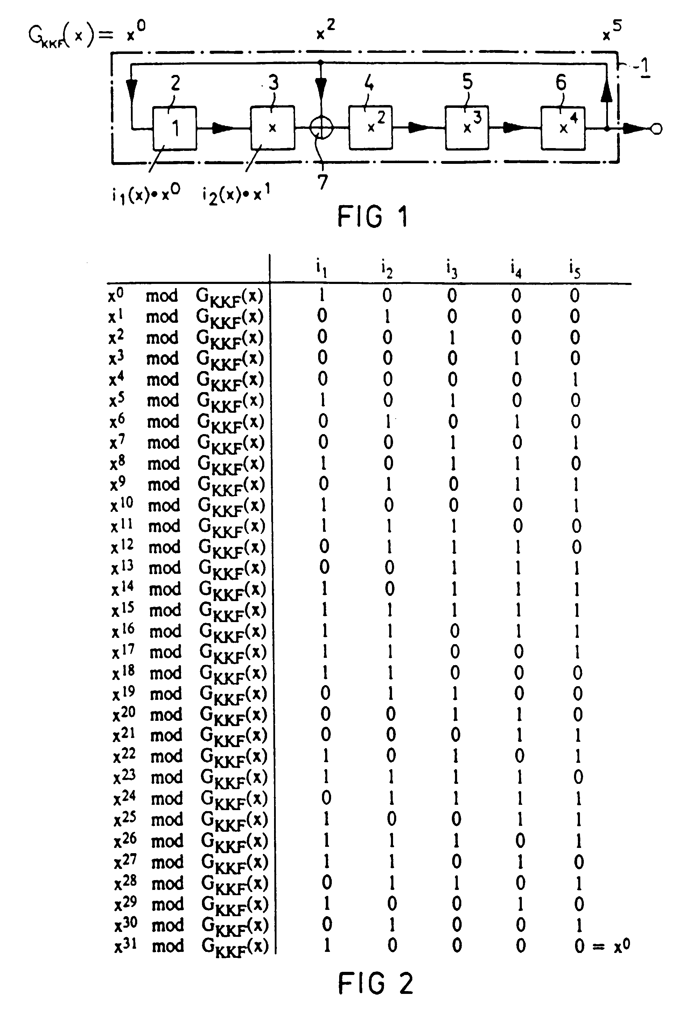

Ein solches Schieberegister ist beispielsweise aus dem Buch von A. Wolf "Meßtechnik für das BISDN", VDE-Verlag 1992, Seiten 72 bis 75 oder aus dem Buch von U. Tietze/Ch. Schenk "Halbleiter-Schaltungstechnik", Springer-Verlag 1976, Seiten 590 bis 593 bekannt. In Figur 1 ist ein solches bekanntes Schieberegister 1 dargestellt, das fünf Stufen 2, 3, 4, 5 und 6 enthält, die beispielsweise jeweils von einem D-Flip-Flop gebildet sind. Das Schieberegister 1 ist in der aus der Figur 1 ersichtlichen Weise rückgekoppelt, wobei zwischen den Stufen 3 und 4 ein Exclusiv-ODER-Glied 7 angeordnet ist. Diese Rückkopplung ist durch folgendes Generatorpolynom $G_{KKF}(x)$ beschreibbar:

$$G_{KKF}(x) = x^0 + x^2 + x^5 = x^5 + x^2 + 1 \qquad (1)$$

Dieses Generatorpolynom $G_{KKF}(x)$ ist ein sogenanntes irreduzibles Polynom mit dem Grad $g = 5$; die Periode einer hiermit erzeugbaren $2^5$-m-Sequenz als Pseudozufallszahlenfolge beträgt $2^9 - 1 = 31$.

Bei dem in der Figur 1 dargestellten bekannten Schieberegister ist sowohl der allen Stufen gemeinsame Taktgenerator als auch der übliche Blockierungsschutz aus Gründen einer möglichst einfachen Darstellung nicht gezeigt. Es werden bei dem bekannten Schieberegister alle Stufen mit demselben Taktsignal beaufschlagt, wodurch sich bei jedem Taktsignal die Inhalte $i_1(x).x^0$, $i_2(x).x^1$, usw. der einzelnen Stufen 2 bis 6 ändern. Die Inhalte der einzelnen Stufen sind durch das in der folgenden Gleichung (2) angegebene Polynom I(x) beschreibbar:

$$I(x) = x^{4\cdot}i_5 + x^{3\cdot}i_4 + x^{2\cdot}i_3 + x^{1\cdot}i_2 + x^{0\cdot}i_1 \qquad (2)$$

Dabei ist der Zustand ausgenommen, daß alle Stufen einen Inhalt "0" aufweisen.

Die Inhalte des Schieberegisters bilden in bekannter Weise die Zeilen eines binären Galoisfeldes, und lassen sich allgemein durch die folgende Beziehung (3) beschreiben

$$x^i \bmod G_{KKF}(x), \qquad (3)$$

wenn für i=0 in der ersten Stufe ($x^0$) eine "1" eingeschrieben wird. Es ergeben sich dann für die Inhalte der Stufen 2 bis 6 die in Figur 2 dargestellten Zustände, wenn ein Schieberegister gemäß Fig. 1 verwendet wird. Ab $x^{31}$

wiederholen sich die Zustände der einzelnen Stufen 2 bis 6 aufgrund der Periode von 31 der $2^5$-m-Sequenz. Die $2^5$-m-Sequenz erhält man als binäre Zahlenfolge:

$$c_0(n) = \{0000100101100111110001101110101\}, \qquad (4)$$

welche identisch mit dem Inhalt der Stufe 6 ist.

Eine Unzulänglichkeit der mit dem bekannten Schieberegister erzeugten digitalen Signale ist, daß sie eine Periode von $2^n- 1$ aufweisen, wenn n die Anzahl der Stufen des Schieberegisters bezeichnet, bei der dargestellten $2^5$-m-Sequenz also eine Periodendauer von 31 haben. Deshalb sind die so erzeugten digitalen Signale nicht ohne weiteres zur weiteren digitalen Verarbeitung mit üblichen digitalen Meßwertverarbeitungseinrichtungen geeignet. Dies gilt beispielsweise für den Fall, daß eine Fast-Fourier-Transformation vorgenommen werden soll, für die Voraussetzung ist, daß der Datensatz $2^n$ Werte besitzt.

Der Erfindung liegt die Aufgabe zugrunde, ein rückgekoppeltes Schieberegister zum Erzeugen von Pseudozufallszahlenfolgen darstellenden digitalen Signalen vorzuschlagen, das unabhängig von der Zahl seiner n Stufen stets einen vollen Datensatz $2^n$ liefert.

Zur Lösung dieser Aufgabe taktet bei einem rückgekoppelten Schieberegister der eingangs angegebenen Art erfindungsgemäß der Taktgenerator die n Stufen über eine steuerbare Torschaltung, die von jeweils $2^n$ Taktimpulsen des Taktgenerators einen Taktimpuls sperrt.

Ein wesentlicher Vorteil des erfindungsgemäßen Schieberegisters besteht darin, daß durch die Sperrung bzw. Unterdrückung von jeweils einem Taktimpuls aus einer Reihe von jeweils $2^n$ Taktimpulsen des Taktgenerators das Schieberegister für einen Impuls des Taktgenerators nicht weiter getaktet wird, so daß für diesen einen Taktimpuls die Stufen des Schieberegisters ihren Zustand nicht verändern; dadurch sind die erzeugten digitalen Signale um ein Bit erweitert und die so gewonnene Pseudozufallszahlenfolge bzw. die so gewonnenen digitalen Signale haben eine Periodendauer von 32, wenn man der Betrachtung ein 5-stufiges Schieberegister zugrunde legt. Bei einem 4-stufigen Schieberegister würde sich eine Periodendauer von 16 ergeben, wenn erfindungsgemäß verfahren wird. Das Spektrum einer solchen erweiterten Sequenz ist dabei nur unwesentlich gegenüber dem einer nicht erweiterten Sequenz verändert, so daß sich meßtechnisch keine Beeinträchtigungen bei der Verarbeitung solcher digitaler Signale ergeben. Im übrigen ist - wie die obigen Ausführungen schon haben erkennen lassen - die Erfindung nicht auf irreduzible Polynome 5. Grades beschränkt.

Bei dem erfindungsgemäßen Schieberegister kann die steuerbare Torschaltung in unterschiedlicher Weise ausgebildet sein, sofern sie gestattet, von jeweils $2^n$ Taktimpulsen des Taktgenerators einen Taktimpuls auszublenden. Als vorteilhaft wird es angesehen, wenn die steuerbare Torschaltung ein Tor-Glied mit zwei Eingängen enthält, dessen einer Eingang mit dem Taktgenerator und dessen anderer Eingang mit einer Steuerschaltung verbunden ist, und wenn die Steuerschaltung während jeweils $2^n$ Taktimpulsen für die Dauer eines Taktimpulses durch Abgabe eines Steuersignals das Tor-Glied sperrt. Dies kann beispielsweise durch eine Zählschaltung erreicht werden, die vom Taktgenerator her beaufschlagt ist.

Im Hinblick auf einen möglichst geringen schaltungstechnischen Aufwand wird es als besonders vorteilhaft angesehen, wenn die Steuerschaltung von einem digitalen Schaltungsbaustein gebildet ist, der eingangsseitig mit den n-Stufen des Schieberegisters verbunden ist und bei einem vorgegebenen Inhalt dieser Stufen das Steuersignal erzeugt, und wenn der Ausgang des digitalen Schaltungsbausteins mit dem anderen Eingang des Tor-Gliedes verbunden ist.

Das Tor-Glied kann bei dem erfindungsgemäßen Schieberegister in schaltungstechnisch besonders einfacher Weise von einem UND-Glied gebildet sein.

Zur weiteren Erläuterung der Erfindung ist in

Figur 3    ein Ausführungsbeispiel des erfindungsgemäßen Schieberegisters, in

Figur 4    eine Darstellung von bei dem Ausführungsbeispiel nach Figur 3 auftretenden Impulsen und in

Figur 5    eine tabellarische Aufstellung der Zustände der Stufeninhalte des Schieberegisters nach Figur 3 wiedergegeben.

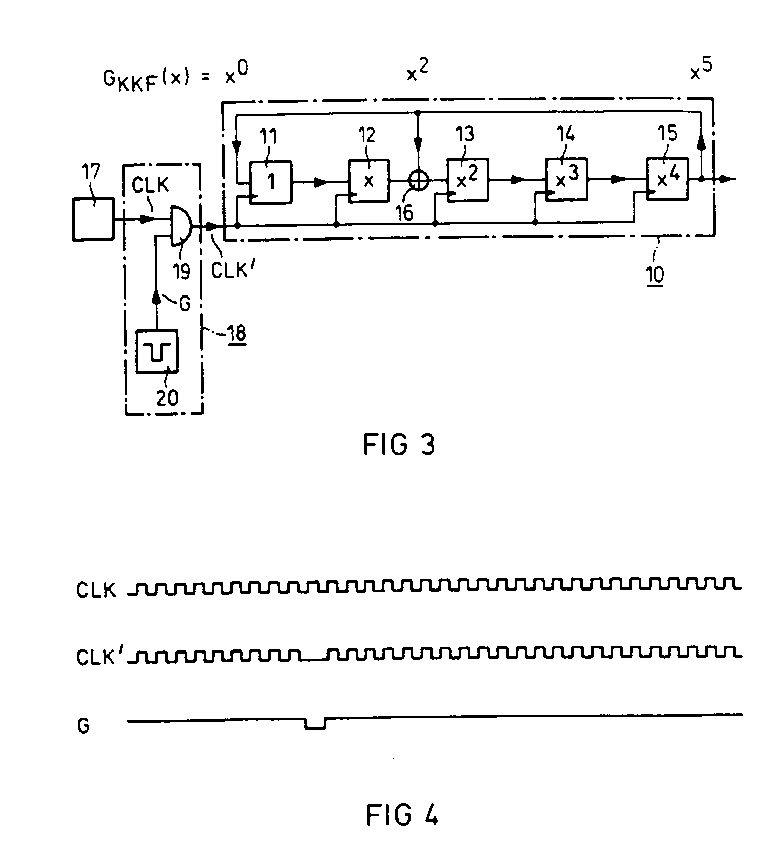

Das in Figur 3 dargestellte Schieberegister 10 ist entsprechend dem nach Figur 1 insofern aufgebaut, als es ebenfalls mit fünf Stufen 11, 12, 13, 14 und 15 versehen ist, wobei auch hier eine Rückkopplung über ein Exclusiv-ODER-Glied 16 erfolgt. Dem Schieberegister 10 ist auch hier ein Taktgenerator 17 zugeordnet, der jedoch nicht unmittelbar mit den Takteingängen der einzelnen Stufen 11 bis 15 des Schieberegisters 10 verbunden ist, sondern über eine steuerbare Torschaltung 18. Der Taktgenerator 17 gibt Taktimpulse CLK ab. Die Torschaltung 18 weist im dargestellten Ausführungsbeispiel ein als UND-Glied ausgebildetes Tor-Glied 19 und einen Impulsgenerator 20 als Steuerschaltung auf. Dieser Impulsgenerator 20 kann als Zählschaltung ausgebildet sein, die direkt mit dem Taktgenerator 17 verbunden ist und bei jeweils einem vorgegebenen Zählerstand ein Ausgangssignal als Steuersignal G abgibt. Die Steuerschaltung kann aber auch von einem digitalen Schaltungsbaustein gebildet sein, der an die Stufen des Schieberegisters 10 angeschlossen ist und bei einem vorgegebenen Zustand dieser Stufen das Steuersignal G abgibt.

Wie Figur 4 zeigt, gibt der Impulsgenerator 20 nach einer freivorgebbaren, aber bestimmten Anzahl von Impulsen CLK des Taktgenerators 17 das Steuersignal G ab, durch das das UND-Glied 19 für einen Taktimpuls CLK gesperrt wird. Am Ausgang der steuerbaren Torschaltung 18 treten dann die Taktimpulse CLK' auf. Dies bedeutet, daß für einen Takt des Taktgenerators 17 das Schieberegister 10 nicht weitergeschaltet wird, so daß die Zustände der einzelnen Stufen des Schieberegisters 10 für diesen einen Takt ihren Zustand beibehalten. Damit ist die erzeugte $2^5$-m-Sequenz um 1 Bit erweitert.

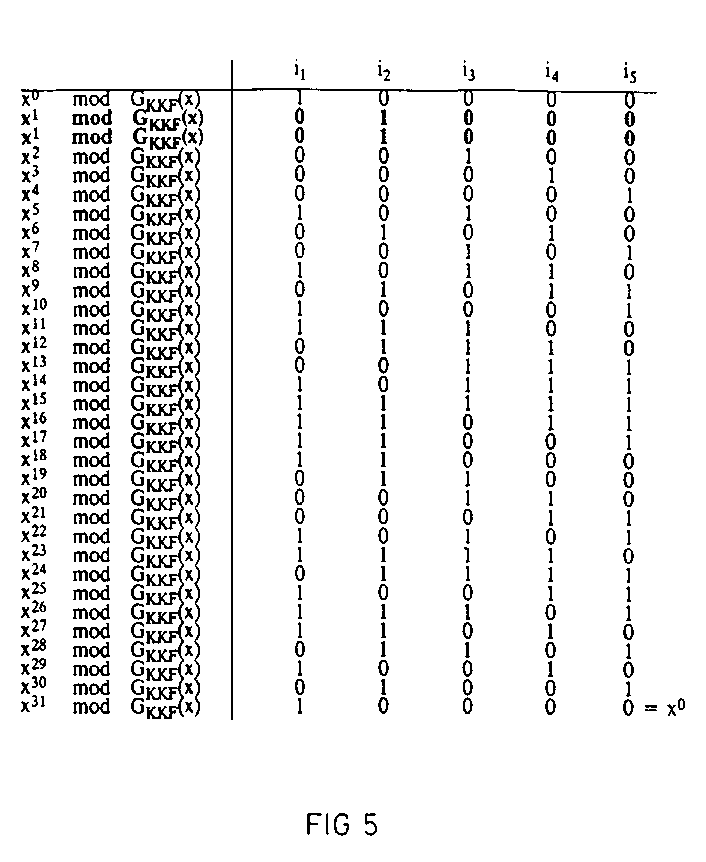

Diesen Sachverhalt läßt auch die Figur 5 deutlich erkennen, in der - ähnlich wie in Figur 2 für das bekannte Schieberegister - die Zustände der einzelnen Stufen 11 bis 15 des Schieberegisters 10 dargestellt sind. Die Zeilen 2 und 3 der Tabelle gemäß Figur 5 zeigen nämlich deutlich, daß der Zustand $x^1$ mod $G_{KKF}(x)$ zweimal erhalten wird, so daß sich eine Periode von 32 bei dem dargestellten 5-stufigen Schieberegister ergibt.

## Patentansprüche

1.  Rückgekoppeltes Schieberegister zum Erzeugen von Pseudozufallsfolgen darstellenden digitalen Signalen mit n Stufen (11, 12, 13, 14, 15) und Exclusiv-ODER-Schaltungen (16) in der Rückkopplungslogik sowie mit einem Taktgenerator (17),
    **dadurch gekennzeichnet,**
    daß der Taktgenerator (17) die n Stufen (11, 12, 13, 14, 15) über eine steuerbare Torschaltung (18) taktet, die von jeweils $2^n$ Taktimpulsen (CLK) des Taktgenerators (17) einen Taktimpuls sperrt.

2.  Schieberegister nach Anspruch 1,
    **dadurch gekennzeichnet** ,
    daß die steuerbare Torschaltung (18) ein Tor-Glied (19) mit zwei Eingängen enthält, dessen einer Eingang mit dem Taktgenerator (17) und dessen anderer Eingang mit einer Steuerschaltung (20) verbunden ist, und daß die Steuerschaltung (20) während jeweils $2^n$ Taktimpulsen (CLK) des Taktgenerators (17) für die Dauer eines Taktimpulses (CLK) durch Abgabe eines Steuersignals (G) das Tor-Glied (19) sperrt.

3.  Schieberegister nach Anspruch 2,
    **dadurch gekennzeichnet** ,
    daß die Steuerschaltung von einem digitalen Schaltungsbaustein gebildet ist, der eingangsseitig mit den n Stufen (11, 12, 13, 14, 15) des Schieberegisters verbunden ist und bei einem vorgegebenen Inhalt dieser Stufen das Steuersignal (G) erzeugt, und daß der Ausgang des digitalen Schaltungsbausteins mit dem anderen Eingang des Tor-Gliedes (19) verbunden ist.

4.  Schieberegister nach einem der vorangehenden Ansprüche 2 und 3,
    **dadurch gekennzeichnet,**

daß das Tor-Glied ein UND-Glied (19) ist.

## Claims

1. Feedback shift register for generating digital signals representing series of pseudo-random numbers, with n stages (11, 12, 13, 14, 15) and exclusive OR circuits (16) in the feedback logic and with a clock generator (17), characterized in that the clock generator (17) clocks the n stages (11, 12, 13, 14, 15) through a controllable gate circuit (18) which blocks one clock pulse out of every $2^n$ clock pulses (CLK) of the clock generator (17).

2. Shift register according to Claim 1, characterized in that the controllable gate circuit (18) includes a gate element (19) with two inputs, of which one input is connected to the clock generator (17) and the other input is connected to a control circuit (20), and in that during each $2^n$ clock pulses (CLK) of the clock generator (17) the control circuit (20) blocks the gate element (19) for the duration of one clock pulse (CLK) by the emission of a control signal (G).

3. Shift register according to Claim 2, characterized in that the control circuit is formed from a digital circuit module which is connected on its input side to the n stages (11, 12, 13, 14, 15) of the shift register and generates the control signal (G) for a defined content of these stages, and in that the output of the digital circuit module is connected to the other input of the gate element (19).

4. Shift register according to either of the preceding Claims 2 or 3, characterized in that the gate element is an AND element (19).

## Revendications

1. Registre à décalage en rétroaction destiné à la production de signaux numériques représentant des suites pseudo-aléatoires, comportant n étages (11, 12, 13, 14, 15) et des circuits (16) OU-Exclusif dans la logique de rétroaction ainsi qu'un générateur (17) de cadence,
caractérisé en ce que
le générateur (17) de cadence cadence les n étages (11, 12, 13, 14, 15) par l'intermédiaire d'un circuit combinatoire (18), qui peut être commandé et qui bloque une impulsion de cadence sur respectivement $2^n$ impulsions de cadence (CLK) du générateur (17) de cadence.

2. Registre à décalage suivant la revendication 1,
caractérisé en ce que
le circuit combinatoire (18) pouvant être commandé comprend un élément (19) de porte à deux entrées, dont une entrée est reliée au générateur (17) de cadence et dont l'autre entrée est reliée à un circuit (20) de commande, et le circuit (20) de commande bloque pendant respectivement $2^n$ impulsions (CLK) de cadence du générateur (17) de cadence, pour la durée d'une impulsion (CLK) de cadence, l'élément (19) de porte en fournissant un signal (G) de commande.

3. Registre à décalage suivant la revendication 2,
caractérisé en ce que
le circuit de commande est formé d'un composant de circuit numérique, qui est relié en entrée aux n étages (11, 12, 13, 14, 15) du registre à décalage et qui produit, pour un contenu prescrit de ces étages, le signal (G) de commande, et la sortie du composant de circuit numérique est reliée à l'autre entrée de l'élément (19) de porte.

4. Registre à décalage suivant l'une des revendications précédentes 2 et 3,
caractérisé en ce que
l'élément de porte est un élément (19) ET.

$$G_{KKF}(x) = x^0 \qquad x^2 \qquad x^5$$

| 2 | 3 | 4 | 5 | 6 |
|---|---|---|---|---|
| 1 | x | $x^2$ | $x^3$ | $x^4$ |

$i_1(x) \cdot x^0 \qquad i_2(x) \cdot x^1$

7

## FIG 1

| | | | $i_1$ | $i_2$ | $i_3$ | $i_4$ | $i_5$ |
|---|---|---|---|---|---|---|---|
| $x^0$ | mod | $G_{KKF}(x)$ | 1 | 0 | 0 | 0 | 0 |
| $x^1$ | mod | $G_{KKF}(x)$ | 0 | 1 | 0 | 0 | 0 |
| $x^2$ | mod | $G_{KKF}(x)$ | 0 | 0 | 1 | 0 | 0 |
| $x^3$ | mod | $G_{KKF}(x)$ | 0 | 0 | 0 | 1 | 0 |
| $x^4$ | mod | $G_{KKF}(x)$ | 0 | 0 | 0 | 0 | 1 |
| $x^5$ | mod | $G_{KKF}(x)$ | 1 | 0 | 1 | 0 | 0 |
| $x^6$ | mod | $G_{KKF}(x)$ | 0 | 1 | 0 | 1 | 0 |
| $x^7$ | mod | $G_{KKF}(x)$ | 0 | 0 | 1 | 0 | 1 |
| $x^8$ | mod | $G_{KKF}(x)$ | 1 | 0 | 1 | 1 | 0 |
| $x^9$ | mod | $G_{KKF}(x)$ | 0 | 1 | 0 | 1 | 1 |
| $x^{10}$ | mod | $G_{KKF}(x)$ | 1 | 0 | 0 | 0 | 1 |
| $x^{11}$ | mod | $G_{KKF}(x)$ | 1 | 1 | 1 | 0 | 0 |
| $x^{12}$ | mod | $G_{KKF}(x)$ | 0 | 1 | 1 | 1 | 0 |
| $x^{13}$ | mod | $G_{KKF}(x)$ | 0 | 0 | 1 | 1 | 1 |
| $x^{14}$ | mod | $G_{KKF}(x)$ | 1 | 0 | 1 | 1 | 1 |
| $x^{15}$ | mod | $G_{KKF}(x)$ | 1 | 1 | 1 | 1 | 1 |
| $x^{16}$ | mod | $G_{KKF}(x)$ | 1 | 1 | 0 | 1 | 1 |
| $x^{17}$ | mod | $G_{KKF}(x)$ | 1 | 1 | 0 | 0 | 1 |
| $x^{18}$ | mod | $G_{KKF}(x)$ | 1 | 1 | 0 | 0 | 0 |
| $x^{19}$ | mod | $G_{KKF}(x)$ | 0 | 1 | 1 | 0 | 0 |
| $x^{20}$ | mod | $G_{KKF}(x)$ | 0 | 0 | 1 | 1 | 0 |
| $x^{21}$ | mod | $G_{KKF}(x)$ | 0 | 0 | 0 | 1 | 1 |
| $x^{22}$ | mod | $G_{KKF}(x)$ | 1 | 0 | 1 | 0 | 1 |
| $x^{23}$ | mod | $G_{KKF}(x)$ | 1 | 1 | 1 | 1 | 0 |
| $x^{24}$ | mod | $G_{KKF}(x)$ | 0 | 1 | 1 | 1 | 1 |
| $x^{25}$ | mod | $G_{KKF}(x)$ | 1 | 0 | 0 | 1 | 1 |
| $x^{26}$ | mod | $G_{KKF}(x)$ | 1 | 1 | 1 | 0 | 1 |
| $x^{27}$ | mod | $G_{KKF}(x)$ | 1 | 1 | 0 | 1 | 0 |
| $x^{28}$ | mod | $G_{KKF}(x)$ | 0 | 1 | 1 | 0 | 1 |
| $x^{29}$ | mod | $G_{KKF}(x)$ | 1 | 0 | 0 | 1 | 0 |
| $x^{30}$ | mod | $G_{KKF}(x)$ | 0 | 1 | 0 | 0 | 1 |
| $x^{31}$ | mod | $G_{KKF}(x)$ | 1 | 0 | 0 | 0 | 0 | $= x^0$ |

## FIG 2

$$G_{KKF}(x) = x^0 \qquad x^2 \qquad x^5$$

FIG 3

CLK

CLK'

G

FIG 4

| | | | $i_1$ | $i_2$ | $i_3$ | $i_4$ | $i_5$ |
|---|---|---|---|---|---|---|---|
| $x^0$ | mod | $G_{KKF}(x)$ | 1 | 0 | 0 | 0 | 0 |
| $x^1$ | **mod** | $G_{KKF}(x)$ | **0** | **1** | **0** | **0** | **0** |
| $x^1$ | **mod** | $G_{KKF}(x)$ | **0** | **1** | **0** | **0** | **0** |
| $x^2$ | mod | $G_{KKF}(x)$ | 0 | 0 | 1 | 0 | 0 |
| $x^3$ | mod | $G_{KKF}(x)$ | 0 | 0 | 0 | 1 | 0 |
| $x^4$ | mod | $G_{KKF}(x)$ | 0 | 0 | 0 | 0 | 1 |
| $x^5$ | mod | $G_{KKF}(x)$ | 1 | 0 | 1 | 0 | 0 |
| $x^6$ | mod | $G_{KKF}(x)$ | 0 | 1 | 0 | 1 | 0 |
| $x^7$ | mod | $G_{KKF}(x)$ | 0 | 0 | 1 | 0 | 1 |
| $x^8$ | mod | $G_{KKF}(x)$ | 1 | 0 | 1 | 1 | 0 |
| $x^9$ | mod | $G_{KKF}(x)$ | 0 | 1 | 0 | 1 | 1 |
| $x^{10}$ | mod | $G_{KKF}(x)$ | 1 | 0 | 0 | 0 | 1 |
| $x^{11}$ | mod | $G_{KKF}(x)$ | 1 | 1 | 1 | 0 | 0 |
| $x^{12}$ | mod | $G_{KKF}(x)$ | 0 | 1 | 1 | 1 | 0 |
| $x^{13}$ | mod | $G_{KKF}(x)$ | 0 | 0 | 1 | 1 | 1 |
| $x^{14}$ | mod | $G_{KKF}(x)$ | 1 | 0 | 1 | 1 | 1 |
| $x^{15}$ | mod | $G_{KKF}(x)$ | 1 | 1 | 1 | 1 | 1 |
| $x^{16}$ | mod | $G_{KKF}(x)$ | 1 | 1 | 0 | 1 | 1 |
| $x^{17}$ | mod | $G_{KKF}(x)$ | 1 | 1 | 0 | 0 | 1 |
| $x^{18}$ | mod | $G_{KKF}(x)$ | 1 | 1 | 0 | 0 | 0 |
| $x^{19}$ | mod | $G_{KKF}(x)$ | 0 | 1 | 1 | 0 | 0 |
| $x^{20}$ | mod | $G_{KKF}(x)$ | 0 | 0 | 1 | 1 | 0 |
| $x^{21}$ | mod | $G_{KKF}(x)$ | 0 | 0 | 0 | 1 | 1 |
| $x^{22}$ | mod | $G_{KKF}(x)$ | 1 | 0 | 1 | 0 | 1 |
| $x^{23}$ | mod | $G_{KKF}(x)$ | 1 | 1 | 1 | 1 | 0 |
| $x^{24}$ | mod | $G_{KKF}(x)$ | 0 | 1 | 1 | 1 | 1 |
| $x^{25}$ | mod | $G_{KKF}(x)$ | 1 | 0 | 0 | 1 | 1 |
| $x^{26}$ | mod | $G_{KKF}(x)$ | 1 | 1 | 1 | 0 | 1 |
| $x^{27}$ | mod | $G_{KKF}(x)$ | 1 | 1 | 0 | 1 | 0 |
| $x^{28}$ | mod | $G_{KKF}(x)$ | 0 | 1 | 1 | 0 | 1 |
| $x^{29}$ | mod | $G_{KKF}(x)$ | 1 | 0 | 0 | 1 | 0 |
| $x^{30}$ | mod | $G_{KKF}(x)$ | 0 | 1 | 0 | 0 | 1 |
| $x^{31}$ | mod | $G_{KKF}(x)$ | 1 | 0 | 0 | 0 | 0 = $x^0$ |

FIG 5